# EUROPEAN PATENT SPECIFICATION

(11) **EP 0 637 777 B1**
(45) Date of publication and mention of the grant of the patent: **09.10.1996**
(21) Application number: 94201850.8
(22) Date of filing: 28.06.1994
(51) Int. Cl.: G03F 7/07, G03C 8/06

(54) **Imaging element and method for making lithographic printing plates according to the silver salt diffusion transfer process**
Bildelement und Verfahren zur Herstellung lithographischer Druckplatten nach dem Silbersalz-Diffusionübertragungsverfahren
Elément porteur d'image et procédé de préparation de plaques d'impression lithographiques selon le procédé de diffusion-transfert de sel d'argent

(30) Priority: 05.08.1993 EP 93202310
(43) Date of publication of application: 08.02.1995
(73) Proprietor: AGFA-GEVAERT naamloze vennootschap, B-2640 Mortsel (BE)
(72) Inventor: Coppens, Paul, c/o Agfa-Gevaert N.V., B-2640 Mortsel (BE); Hoes, Eric, c/o Agfa-Gevaert N.V., B-2640 Mortsel (BE); Vervloet, Ludovicus, c/o Agfa-Gevaert N.V., B-2640 Mortsel (BE)

(56) References cited:
- EP-A- 0 483 415
- US-A- 4 510 228

## Description

### 1. Field of the invention.

The present invention relates to an imaging element for making improved offset printing plates according to the silver salt diffusion transfer process. Furthermore the present invention relates to a method for making improved offset printing plates with said imaging element.

### 2. Background of the invention.

The principles of the silver complex diffusion transfer reversal process, hereinafter called DTR-process, have been described e.g. in US-P 2,352,014 and in the book "Photographic Silver Halide Diffusion Processes" by André Rott and Edith Weyde - The Focal Press - London and New York, (1972).

In the DTR-process non-developed silver halide of an information-wise exposed photographic silver halide emulsion layer material is transformed with a so-called silver halide solvent into soluble silver complex compounds which are allowed to diffuse into an image receiving layer and are reduced therein with a developing agent, generally in the presence of physical development nuclei, to form a silver image having reversed image density values ("DTR-image") with respect to the black silver image obtained in the exposed areas of the photographic material.

A DTR-image bearing material can be used as a planographic printing plate wherein the DTR-silver image areas form the water-repellant-ink-receptive areas on a water-receptive ink-repellant background. The DTR-image can be formed in the image receiving layer of a sheet or web material which is a separate element with respect to the photographic silver halide emulsion material (a so-called two-sheet DTR element) or in the image receiving layer of a so-called single-support-element, also called mono-sheet element, which contains at least one photographic silver halide emulsion layer integral with an image receiving layer in waterpermeable relationship therewith. It is the latter mono-sheet version which is preferred for the preparation of offset printing plates by the DTR method.

Two main types of mono-sheet DTR materials that are distinct because of their different layer arrangement and processing are known. The first type of mono-sheet DTR material comprises on a support, generally paper or a resin support such as polyester, in the order given a silver halide emulsion layer and an image receiving layer containing physical development nuclei as a surface layer. After information-wise exposure and development according to the DTR process a silver image is formed in the surface layer. Since the underlying layers are hydrophilic in nature and the silver image formed on the surface is hydrophobic or can be renderred hydrophobic the thus obtained plate can be used without further processing. These type of printing plates have a low printing endurance typically around 10000 copies.

On the other hand mono-sheet DTR materials are known that comprise a hydrophilic support provided with an image receiving layer containing physical development nuclei and on top thereof a silver halide emulsion layer. After information-wise exposure and development according to the DTR-process a silver image is formed in the image receiving layer. In order to obtain a lithographic printing plate it will then be necessary to remove the now useless silver halide emulsion layer to uncover the silver image formed in the image receiving layer. Said removal is generally carried out by rinsing the element with cold or warm water. This type of printing plate is disclosed e.g. in EP-A-278766, EP-A-483415 and EP-A-410500.

As for other printing plates it is required that the printing plates obtained according to the above described DTR-process have a high printing endurance, good ink acceptance in the printing areas and no ink acceptance in the non-printing areas (no staining). With respect to these requirements it has been experimentally stated that that the complete removal of all of the gelatin of said emulsion layer (or any other gelatin containing layer) from the silver image formed in the image receiving layer is of the uttermost importance. Even by applying intermediate layers, facilitating the removal of said gelatin layer(s) as disclosed in EP-A-483415 and EP-A-410500, there remain spots of gelatin on said silver image formed in the rimage receiving layer especially when the removal of said gelatin layer(s) is made with rinsing water at room temperature, resulting in bad ink acceptance in the printing areas.

### 3. Summary of the invention.

It is an object of the present invention to provide an imaging element for making offset printing plates according to the silver salt diffusion transfer process with improved printing properties.

It is another object of the present invention to provide a method for making offset printing plates with said imaging element having improved printing properties.

Further objects of the present invention will become clear from the description hereinafter.

According to the present invention there is provided an imaging element comprising in the order given (i) a hydrophilic base, (ii) an image receiving layer containing physical development nuclei and (iii) a photosensitive layer containing a silver halide emulsion being in water permeable relationship with said image receiving layer, characterized in that said photosensitive layer and/or another optional layer being in water permeable relationship therewith contains at least one gelatin species whereof a 10 % by weight aqueous solution at 36 °C and pH 6 has a viscosity lower than 20 mPas at a shearing rate of 1000 s⁻¹ and a gelatin whereof a 10 % by weight aqueous solution at 36 °C and pH 6 has a viscosity of at least 20 mPas at a shearing rate of 1000 s⁻¹, the weight ratio in said layer of said gelatin of a lower viscosity versus said gelatin of a higher viscosity being > 0.1.

According to the present invention there is also provided a method for making an offset printing plate according to the silver salt diffusion transfer process having improved printing properties comprising the steps of:
(a) image-wise exposing an imaging element comprising in the order given (i) a hydrophilic base, (ii) an image receiving layer containing physical development nuclei and (iii) a photosensitive layer containing a silver halide emulsion being in water permeable relationship with said image receiving layer,
(b) applying an aqueous alkaline solution to the imaging element in the presence of (a) developing agent(s) and (a) silver halide solvent(s) to form a silver image in said photosensitive layer and to allow unreduced silver halide or complexes formed thereof to diffuse image-wise from the photosensitive layer to said image receiving layer to produce therein a silver image,
(c) treating the imaging element to remove the layer(s) on top of said image receiving layer, thereby uncovering said silver image formed in said image receiving layer, characterized in that said photosensitive layer and/or another optional layer being in water permeable relationship therewith contains at least one gelatin species whereof a 10 % by weight aqueous solution at 36 °C and pH 6 has a viscosity lower than 20 mPas at a shearing rate of 100 s⁻¹ and a gelatin whereof a 10 % by weight aqueous solution at 36 °C and pH 6 has a viscosity of at least 20 mPas at a shearing rate of 1000 s⁻¹, the weight ratio in said layer of said gelatin of a lower viscosity versus said gelatin of a higher viscosity being > 0.1

### 4. Detailed description of the invention.

According to the present invention it has been found that a lithographic printing plate prepared according to the DTR-process by using an imaging element, characterized in that the photosensitive layer and/or another optional layer being in water permeable relationship therewith contains a gelatin with a low viscosity has good printing properties, especially good ink acceptance in the printing areas.

US-A-4.510.228 discloses in order to improve the printing endurance of a lithographic printing plate a photosensitive element for the production of lithographic printing plates comprising in the order given on a support (i) a layer comprising a silver halide emulsion and (ii) a physical development nuclei layer, wherein at least one of the gelatin containing layers of said photosensitive element comprises a combination of photographic gelatin and a low-molecular weight gelatin. From this disclosure one could not deduce that a combination of a photographic gelatin and a low-viscosity gelatin could improve the ink acceptance of a lithographic plate obtained from an imaging element comprising on a hydrophilic base in the order given (i) a physical development nuclei layer and (ii) a layer comprising a silver halide emulsion

As employed herein, viscosity values in mPas measured at a shearing rate of 1000 s⁻¹ refer to viscosities measured at 36 °C and pH = 6 of a 10 % by weight aqueous gelatin solutions using a viscosimeter operating with a rotating cylinder and marketed under the tradename HAAKE ROTOVISCO rheometer Type M 10, wherein the cylinder can be rotated at 1000 rpm and a maximal shearing rate of 44,500 s⁻¹.

According to the invention the photosensitive layer and/or another optional layer being in water permeable relationship therewith contains at least one gelatin with a viscosity lower than 20 mPas. The lower limit is not very important but should preferably be higher than 5 mPas. More preferably the viscosity of said gelatin is lower than 15 mPas.

Layers being in waterpermeable contact with each other are layers that are contiguous to each other or only separated from each other by (a) waterpermeable layer(s). The nature of a waterpermeable layer is such that it does not substantially inhibit or restrain the diffusion of water or of compounds contained in an aqueous solution e.g. developing agents or complexed silver ions.

The layer(s) containing at least one gelatin with a viscosity lower than 20 mPas can be any layer(s) on top of the image receiving layer being in water permeable relationship with the photosensitive layer. Preferably said gelatin is contained in the photosensitive layer and is preferably added thereto after the physical ripening of the AgX grains

Said gelatin is combined with a gelatin of a higher viscosity. The weight ratio of said low viscosity gelatin versus the gelatin of a higher viscosity is preferably > 0.1, more preferably > 0.5.

Preferably the gelatin layer(s) is (are) substantially unhardened. Substantially unhardened means that when such gelatin layer is coated on a subbed polyethylene terephtalate film base at a dry thickness of 1.2 g/m², dried for 3 days at 57 C° and 35% R.H. and dipped in water of 30 C°, said gelatin layer is dissolved for >95 % by weight within 5 minutes.

The imaging element is preferably prepared by coating the different layers on a hydrophilic base. Alternatively the different layers may be laminated to said image receiving layer from a temporary base holding the layers in reverse order as disclosed in US-P 5,068,165.

The hydrophilic base can be a hardened hydrophilic layer, containing a hydrophilic synthetic homopolymer or copolymer and being hardened with a hydrolyzed tetraalkyl orthosilicate crosslinking agent coated on a flexible hydrophobic support. More preferably an aluminum support is used as a hydrophilic base.

The aluminum support of the imaging element for use in accordance with the present invention can be made of pure aluminum or of an aluminum alloy, the aluminum content of which is at least 95%. The thickness of the support usually ranges from about 0.13 to about 0.50 mm.

The preparation of aluminum or aluminum alloy foils for lithographic offset printing comprises the following steps : graining, anodizing, and optionally sealing of the foil.

Graining and anodization of the foil are necessary to obtain a lithographic printing plate that allows to produce high-quality prints in accordance with the present invention. Sealing is not necessary but may still improve the printing results. Preferably the aluminum foil has a roughness with a CLA value between 0.2 and 1.5 µm, an anodization layer with a thickness between 0.4 and 2.0 µm and is sealed with an aqueous bicarbonate solution.

The graining, anodizing, and sealing of the aluminum foil can be performed as described in e.g. in EP-A 567178, US-P-3,861,917 and in the documents referred to therein.

To promote the image sharpness and, as a consequence thereof, the sharpness of the final printed copy, the anodization layer may be coloured in the mass with an antihalation dye or pigment e.g. as described in JA-Pu-58-14,797.

The image receiving layer for use in accordance with the present invention is preferably free of hydrophilic binder but may comprise small amounts up to 30% by weight of the total weight of said layer of a hydrophilic colloid e.g. polyvinyl alcohol to improve the hydrophilicity of the layer.

Preferred development nuclei for use in accordance with the present invention are sulphides of heavy metals e.g. sulphides of antimony, bismuth, cadmium, cobalt, lead, nickel, palladium, platinum, silver, and zinc. Other suitable development nuclei are heavy metal salts such as e.g. selenides, polyselenides, polysulphides, mercaptans, and tin (II) halides. Heavy metals, preferably silver, gold, platinum, palladium, and mercury can be used in colloidal form. More preferred development nuclei for use in accordance with the present invention are nuclei, especially sulphides of heavy metals having an average diameter less than 6 nm and wherein the number of nuclei having a diameter larger than 4.5 nm is less than 15% of the total number of nuclei contained in said image receiving layer as disclosed in EP-A 546598. Especially preferred development nuclei in connection with the present invention are palladium sulphide nuclei having an average diameter less than 6 nm and wherein the number of nuclei having a diameter larger than 4.5 nm is less than 15% of the total number of nuclei contained in said image receiving layer.

To promote the image sharpness and, as a consequence thereof, the sharpness of the final printed copy, the hydrophilic base can be provided with a very thin antihalation coating of a dye or pigment, which may be applied before or after said image receiving layer is applied. Also to promote the image sharpness the image receiving layer may incorporate at least one antihalation dye or pigment. The usual dyes and pigments can be chosen such that they prevent or reduce halation in the silver halide emulsions having any desired photosensitivity range comprised between 300 and 900 nm.

The photosensitive layer used in accordance with the present invention may be any silver halide emulsion layer comprising a hydrophilic colloid binder, at least one of the silver halide emulsions being photosensitive.

The photographic silver halide emulsion(s) for coating silver halide emulsion layers in accordance with the present invention can be prepared from soluble silver salts and soluble halides according to different methods as described e.g. by P. Glafkides in "Chimie et Physique Photographique", Paul Montel, Paris (1967), by G.F. Duffin in "Photographic Emulsion Chemistry", The Focal Press, London (1966), and by V.L. Zelikman et al in "Making and Coating Photographic Emulsion", The Focal Press, London (1966).

According to the present invention the silver halide emulsion or emulsions preferably consist principally of silver chloride while a fraction of silver bromide may be present ranging from 1 mole % to 40 mole %. The silver halide emulsions preferably belong to the core/shell type well known to those skilled in the art in the sense that substantially all the bromide is concentrated in the core. This core contains preferably 10 to 40 % of the total silver halide precipitated, while the shell consists preferably of 60 to 90 % of the total silver halide precipitated. Most preferably a silver halide emulsion containing at least 70 mole% of silver chloride is used.

The average size of the silver halide grains may range from 0.10 to 0.70 µm , preferably from 0.25 to 0.45 µm.

Preferably during the precipitation stage iridium and/or rhodium containing compounds or a mixture of both are added. The concentration of these added compounds ranges from 10⁻⁸ to 10⁻³ mole per mole of AgNO₃, preferably between 10⁻⁷ and 10⁻⁶ mole per mole of AgNO₃.

The silver halide emulsions can be chemically sensitized. A method of chemical sensitization has been described in the article of R.KOSLOWSKY, Z. Wiss. Photogr. Photophys. Photochem. 46, 65-72 (1951).

The silver halide emulsions of the DTR-element can be spectrally sensitized according to the spectral emission of the exposure source for which the DTR element is designed.

Suitable sensitizing dyes for the visible spectral region include methine dyes such as those described by F.M. Hamer in "The Cyanine Dyes and Related Compounds", 1964, John Wiley & Sons.

The spectral photosensitivity of the silver halide can also be adjusted for exposure by laser light e.g. helium-neon laser light, argon laser light, and solid state laser light. Dyes that can be used for adjusting the photosensitivity to laser light have been disclosed i.a. in the documents cited in EP-A-610977 and US-P-5,200,294.

The silver halide emulsions may contain the usual emulsion stabilizers. Suitable emulsion stabilizers are azaindenes, preferably tetra- or penta-azaindenes, especially those substituted with hydroxy or amino groups. Compounds of this kind have been described by BIRR in Z. Wiss. Photogr. Photophys. Photochem. 47, 2-27 (1952). Other suitable emulsion stabilizers are i.a. heterocyclic mercapto compounds. Especially good results are obtained with the substituted 1-phenyl 5-mercapto-tetrazole compounds in accordance with the present invention, alone or in combination with other emulsion stabilizers.

As binder in the silver halide emulsion layer(s) in connection with the present invention a hydrophilic colloid may be used, usually a protein, preferably gelatin. Gelatin can, however, be replaced in part or integrally by synthetic, semi-synthetic, or natural polymers.

The silver halide emulsions may contain pH controlling ingredients. Preferably at least one gelatin containing layer is coated at a pH value not below its iso-electric point to avoid interactions between said gelatin containing coated layer and the hereafter mentioned intermediate layer. More preferably the gelatin layer contiguous to said intermediate layer is coated at a pH value not below its iso-electric point. Most preferably all the gelatin containing layers are coated at a pH value not below their isoelectric point. Other ingredients such as antifogging agents, development accelerators, wetting agents, and hardening agents for gelatin may be present. The silver halide emulsion layer may comprise light-screening dyes that absorb scattering light and thus promote the image sharpness. Suitable light-absorbing dyes are described in i.a. US-P-4,092,168, US-P-4,311,787, DE-P-2,453,217.

More details about the composition, preparation and coating of silver halide emulsions can be found in e.g. Product Licensing Index, Vol. 92, December 1971, publication 9232, p. 107-109.

The imaging element preferably also comprises an intermediate layer between the image receiving layer on the hydrophilic base and the photosensitive layer(packet) to facilate the removal of said layer(packet) thereby uncovering the silver image formed in the image receiving layer by processing the imaging element.

In one embodiment, the intermediate layer can be a water-swellable intermediate layer coated at a ratio of 0.01 to 2.0 g/m2 and comprising at least one non-proteinic hydrophilic film-forming polymer and optionally comprising an antihalation dye or pigment as disclosed in EP-A-410500.

In another embodiment, the intermediate layer can be a layer comprising hydrophobic polymer beads having an average diameter not lower than 0.2 µm and having been prepared by polymerization of at least one ethylenically unsaturated monomer. Preferably, said intermediate layer in dry condition comprises said hydrophobic polymer beads in an amount of up to 80% of its total weight. Further details are disclosed in EP-A-483415.

A supplemental intermediate layer, which may be present between said silver halide emulsion containing layer and said water-swellable intermediate layer or said intermediate layer comprising hydrophobic polymer beads may incorporate one or more ingredients such as i.a. antihalation dyes or pigment, developing agents, silver halide solvents, base precursors, and anticorrosion substances.

When the imaging element is prepared by laminating a photosensitive layer or layer packet onto the image receiving layer the intermediate layer(s) are contained in the photosensitive layer packet, the water-swellable intermediate layer or the intermediate layer comprising hydrophobic polymer beads having an average diameter not lower than 0.2 µm and having been prepared by polymerization of at least one ethylenically unsaturated monomer being the upper layer.

A wide choice of cameras for exposing the photosensitive silver halide emulsion exists on the market. Horizontal, vertical and darkroom type cameras and contact-exposure apparatus are available to suit any particular class of reprographic work. The imaging element in accordance with the present invention can also be exposed with the aid of i.a. laser recorders and cathode rays tubes.

The development and diffusion transfer are effected with the aid of an aqueous alkaline solution in the presence of (a) developing agent(s) and (a) silver halide solvent(s). The developing agent(s) and/or the silver halide solvent(s) can be incorporated in the aqueous alkaline solution and/or in said silver halide emulsion layer and/or in any of said intermediate layers and/or in a supplemental hydrophilic colloid layer in water-permeable relationship with said silver halide emulsion layer. The latter supplemental hydrophilic colloid layer can be coated on top of said silver halide emulsion layer remotest from said hydrophilic base.

The silver halide solvent can also be incorporated at least in part in the physical development nuclei containing layer. When the aqueous alkaline solution does not comprise the developing agent(s), it is merely an activating liquid that is capable of dissolving the developing agent(s) contained in one of the layers.

Silver halide developing agents for use in accordance with the present invention are preferably of the p-dihydroxybenzene type, e.g. hydroquinone, methylhydroquinone or chlorohydroquinone, preferably in combination with an auxiliary developing agent being a 1-phenyl-3-pyrazolidinone-type developing agent and/or p-monomethylaminophenol. More details are disclosed in EP-A-93201649.6. However other developing agents can be used. Preferred amounts of the hydroquinone-type developing agents are in the range of 0.05 mole to 0.25 mole per litre and preferred amounts of secondary developing agent(s) in the range of 1.8 x 10⁻³ to 2.0 x 10⁻² mole per litre.

The silver halide solvent, which acts as a complexing agent for silver halide, preferably is a water-soluble thiosulphate or thiocyanate e.g. sodium, potassium, or ammonium thiosulphate and sodium, potassium, or ammonium thiocyanate.

Further silver halide solvents that can be used in connection with the present invention are alkanolamines. Alkanolamines that are suitable for use in accordance with the present invention may be of the tertiary, secundary or primary type. Examples of alkanolamines that may be used in connection with the present invention are disclosed in e.g. EP-A 549830.

According to the present invention the alkanolamines are preferably present in the alkaline processing liquid in a concentration preferably between 0.05% and 10% by weight. However part or all of the alkanolamine can be present in one or more layers of the imaging element.

Further suitable silver halide solvents are thioethers. Preferably used thioethers are disclosed in e.g. US-P-4,960,683 and US-P-5,200,294.

Still further suitable silver halide solvents are meso-ionic compounds. Preferred meso-ionic compounds for use in accordance with the present invention are triazolium thiolates and more preferably 1,2,4-triazolium-3-thiolates. More details are disclosed in EP-A 554585.

Still further suitable silver halide solvents are sulphite, amines, 2-mercaptobenzoic acid and those disclosed in "The Theory of the Photographic Process" 4th Ed., edited by T.H.James, pages 474-475. Further interesting silver halide solvents have been described in i.a. US-P-2,857,276, 4,355,090, 4,297,429 and 4,297,430. Among these are cyclic imide compounds such as e.g. uracil and 5,5-dialkylhydantoins. Other suitable silver halide solvents are the alkyl sulfones.

Combinations of different silver halide solvents can be used and it is also possible to incorporate at least one silver halide solvent into a suitable layer of the imaging element and to add at least one other silver halide solvent to the developing solution.

Examples of suitable combinations of different silver halide solvents are a combination of (an) alkanolamine(s) and a thiosulfate as disclosed in EP-A 549831 and 4,6-dihydroxypyrimidines in combination with other silver halide solvents as disclosed in EP-A 549830.

The aqueous alkaline solution may further comprise sulphite e.g. sodium sulphite in an amount ranging from 40 g to 180 g per litre, preferably from 60 to 160 g per litre, and a silver halide solvent, preferably a water soluble thiosulphate and/or thiocyanate in an amount ranging from 5 g to 20 g per litre.

Combinations of at least one silver halide solvent and a regulator may also be used. Suitable regulators are disclosed in EP-A 547660 and in EP-A 576736.

The aqueous alkaline solution used according to the present invention preferably comprises aluminum ions in an amount of at least 0.3 g/l in order to prevent sticking of the emulsion layer to the transporting rollers when the emulsion is swollen with the aqueous alkaline solution. More preferably the aqueous alkaline solution used in accordance with the present invention comprises aluminum ions in an amount of at least 0.6 g/l.

The alkaline processing liquid preferably has a pH between 9 and 14 and more preferably between 10 and 13. Said pH may be established by an organic or inorganic alkaline substance or a combination thereof. Suitable inorganic alkaline substances are e.g. potassium or sodium hydroxide, carbonate, phosphate etc.. Suitable organic alkaline substances are e.g. alkanolamines. In the latter case the alkanolamines will provide or help providing the pH and serve as a silver halide complexing agent.

The processing conditions such as pH, temperature and time may vary within broad ranges provided the mechanical strength of the materials to be processed is not adversely influenced and no decomposition takes place.

The aqueous alkaline solution may further comprise hydrophobizing agents for improving the hydrophobicity of the silver image obtained in the image image receiving layer. Generally these compounds contain a mercapto group or thiolate group and one or more hydrophobic substituents. Examples of hydrophobizing agents are e.g. those described in US-P-3,776,728, and US-P-4,563,410. Particularly preferred hydrophobizing agents are long chain (at least 5 carbon atoms) alkyl substituted mercaptotetrazoles. More details are disclosed in EP-A-628878. The hydrophobizing agents can be used alone or in combination with each other.

The aqueous alkaline solution may comprise other ingredients such as e.g. oxidation preservatives, a compound releasing bromide ions, calcium-sequestering compounds, anti-sludge agents, and hardeners including latent hardeners.

Regeneration of the aqueous alkaline solution according to known methods is, of course, possible, whether the solution incorporates developing agent(s) and/or silver halide solvent(s) or not.

The development may be stopped - though this is often not necessary - with a so-called stabilization liquid, which actually is an acidic stop-bath having a pH preferably in the range of 5 to 6 as disclosed in EP-A-519,123.

The development and diffusion transfer can be initiated in different ways e.g. by rubbing with a roller, by wiping with an absorbent means e.g. with a plug of cotton or sponge, or by dipping the material to be treated in the liquid composition. Preferably, they proceed in an automatically operated apparatus. They are normally carried out at a temperature in the range of 18°C to 30°C.

After formation of the silver image on the lithographic image receiving element an excess of alkaline solution still present on the monosheet layer assemblage may be eliminated, preferably by guiding the monosheet layer assemblage through a pair of squeezing rollers.

The silver image thus obtained in the image receiving layer is subsequently uncovered by treating the imaging element to remove the photosensitive layer and the intermediate layer.

Various embodiments for removing the photosensitive layer and the intermediate layer(s) are disclosed in EP-A 483,415

According to a particularly preferred embodiment for removing the photosensitive layer(s) and the intermediate layer(s) the imaging element is held under a spray or jet of rinsing water or rinsing aqueous medium. The rinsing aqueous medium used to detach the intermediate layer(s) and the emulsion layer(s)(s) by rinsing may comprise ingredients such as i.a. weak acidifying agents, wetting agents, and hardeners including latent hardeners.

The temperature of the rinsing water may be varied widely but is preferably between 20°C and 30°C.

The imaged surface of the lithographic base can be subjected to a chemical treatment that increases the hydrophilicity of the non-silver image parts and the oleophilicity of the silver image.

This chemical after-treatment is preferably carried out with a lithographic composition often called fixer, which comprises at least one compound enhancing the ink-receptivity and/or lacquer-receptivity of the silver image, and also comprises at least one compound that improves the ink-repelling characteristics of the hydrophilic grained and anodized aluminum support. More details are disclosed in EP-A-632326.

At the moment the treatment with the fixer is started the surface carrying the silver pattern may be in dry or wet state. In general, the treatment with the fixer does not take long, usually not longer than about 30 seconds and it may be carried out immediately after the processing and uncovering steps.

The fixer can be applied in different ways such as by rubbing with a roller, by wiping with an absorbent means e.g. with a plug of cotton or sponge, or by dipping the material to be treated in the fixer. The image-hydrophobizing step of the printing plate may also proceed automatically by conducting the printing plate through a device having a narrow channel filled with the fixer and conveying the printing plate at the end of the channel between two squeezing rollers removing the excess of liquid.

The following example illustrates the present invention without however, limiting it thereto. All parts, percentages and ratios are by weight unless otherwise indicated.

### EXAMPLE 1

### Preparation of the silver halide emulsion coating solution 1 to 7.

A silver chlorobromide emulsion composed of 98.2mole% of chloride and 1.8mole% of bromide was prepared by the double jet precipitation method in an aqueous solution containing 35 g/mole AgNO₃ of gelatin A with a viscosity of 21 mPa.s. After precipitation and desalting by washing with demineralized water, the silver halide grains were redispersed by adding one or more of the gelatins A, B (viscosity of 11 mPa.s) or C (viscosity of 40 mPa.s) and water to obtain the required concentration on AgX. The average silver halide grain size was 0.4µm (diameter of a sphere with equivalent volume) and contained Rhodium ions as internal dopant. The emulsions were blue sensitized and stabilized by 1-phenyl-5-mercapto-tetrazole.

The type and amount of gelatin in the various coating compositions, all containing AgX in an amount corresponding to 100 g AgNO₃ are given in Table 1.

**Table 1**

| Solution | gel A (g/l) (21 mPa.s) | gel B (g/l) (11 mPa.s) | gel C (g/l) (40 mPa.s) |
|---|---|---|---|
| 1 | 20 | 0 | 45 |
| 2 | 35 | 0 | 30 |
| 3 | 20 | 15 | 30 |
| 4 | 20 | 45 | 0 |
| 5 | 20 | 0 | 80 |
| 6 | 70 | 0 | 30 |
| 7 | 20 | 50 | 30 |
| 8 | 20 | 80 | 0 |

### Preparation of the imaging elements I to VII

An imaging element I was obtained by coating a grained, anodized and sealed aluminum support with a silver-receptive stratum containing 0.7 mg/m² PdS as physical development nuclei.

An intermediate layer was then provided on the dry silver-receptive stratum from an aqueous composition in such a way that the resulting dried layer had a weight of 0.5 g of polymethyl methacrylate beads per m², said composition comprising:

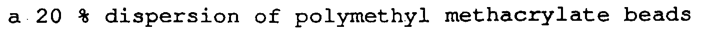

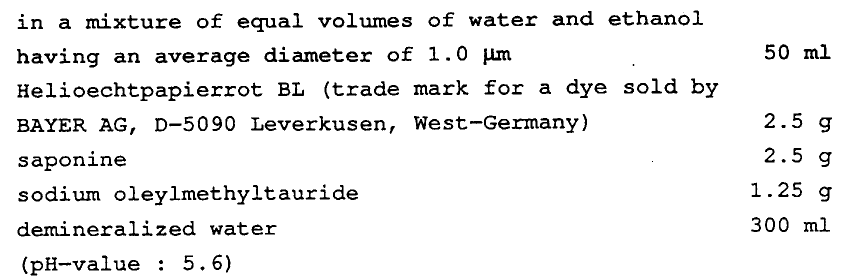

Finally the silver halide emulsion coating solution 1 was coated on the intermediate layer, the silver halide being provided in an amount corresponding to 2.40 g of silver nitrate per m² and the gelatin content of the emulsion layer being 1.58 g/m².

The imaging elements II to VIII were prepared in an identical way except that coating solution 1 was substituted respectively by coating solutions 2 to 8, the silver halide in the imaging elements V to VIII being provided in an amount corresponding to 1.58 g of silver nitrate per m².

The 8 imaging elements were identically exposed through a contact screen in a process-camera and immersed for 8 s at 24°C in a freshly made developing solution having the following ingredients:

| | |
|---|---|
| carboxymethylcellulose | 4 g |
| sodium hydroxide | 22.5 g |
| anhydrous sodium sulphite | 120 g |
| hydroquinone | 20 g |
| 1-phenyl-3-pyrazolidinone | 6 g |
| potassium bromide | 0.75 g |
| anhydrous sodium thiosulphate | 8 g |
| ethylene diamine tetraacetic acid tetrasodium salt | 2 g |
| demineralized water to make | 1000 ml |
| pH (24°C) = 13 | |

The initiated diffusion transfer was allowed to continue for 30 s to form a silver image in the image receiving layers.

To remove the developed silver halide emulsion layer and the intermediate layer from the aluminum foils the developed monosheet DTR materials were rinsed for 30 s with a water jet at 20°C.

Next, the imaged surface of the aluminum foil was rubbed with a fixer to enhance the water-receptivity of the non-image areas and to make the image areas oleophilic ink-receptive. The fixer had the following composition :

| | |
|---|---|
| 10% aqueous n-hexadecyl trimethyl ammonium chloride | 25 ml |
| 20% aqueous solution of polystyrene sulphonic acid | 100 ml |
| potassium nitrate | 12.5 g |
| citric acid | 20.0 g |
| 1-phenyl-5-mercaptotetrazole | 2.0 g |
| sodium hydroxide | 5.5 g |
| water to make | 1000 ml |
| pH (20°C) = 4 | |

The printing plates thus prepared were mounted on the same offset printing machine (Heidelberg GTO-46) and were printed under identical conditions. A commercial dampening solution AQUA TAME (tradename) was used at a 5% concentration for fountain solution, and K+E 125 as ink. A compressible rubber blanket was used. The results are given in the following Table 2.

The ease of gelatin removal and the ink acceptance were evaluated as follows :
a) ease of gelatin removal: the number relates to a visual evaluation on a relative scale from 0 to 5, where 0 stands for a complete removal and 5 for no removal of the intermediate layer and the emulsion layer from the image receiving layer :
b) ink acceptance : the first number indicates the number of copies that has to be printed before a constant print quality with regard to the ink accepting areas is obtained; the second number relates to the presence of white spots in the ink accepting areas of the 25th copy and is visually evaluated on a relative scale from 0 to 5, where 0 stands for a total absence of white spots in the printing areas where 5 indicates a very high number of white spots in the printing areas.

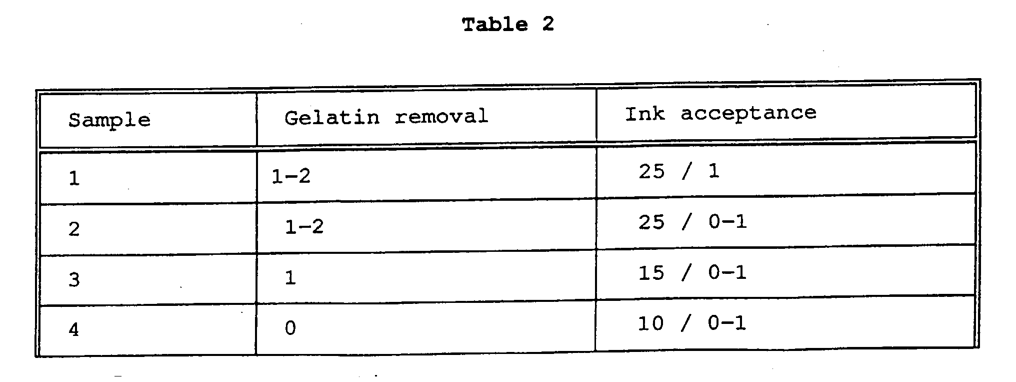

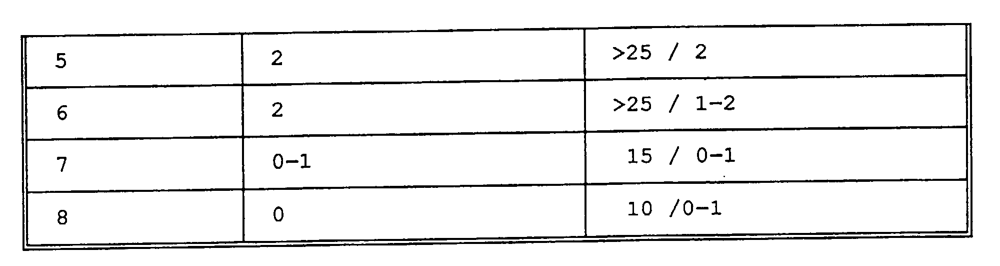

### Evaluation:

From the above it can be seen that when a DTR imaging element is used comprising a gelatin layer containing a gelatin with a viscosity according to the invention, the uncovering of the image receiving layer by using rinsing water at room temperature is effectively performed and printing plates with a good ink acceptance are obtained.

## Claims

1. An imaging element comprising in the order given (i) a hydrophilic base, (ii) an image receiving layer containing physical development nuclei and (iii) a photosensitive layer containing a silver halide emulsion being in water permeable relationship with said image receiving layer, characterized in that said photosensitive layer and/or another optional layer being in water permeable relationship therewith contains at least one gelatin species whereof a 10 % by weight aqueous solution at 36 °C and pH 6 has a viscosity lower than 20 mPas at a shearing rate of 1000 s⁻¹ and a gelatin whereof a 10 % by weight aqueous solution at 36 °C and pH 6 has a viscosity of at least 20 mPas at a shearing rate of 1000 s⁻¹, the weight ratio in said layer of said gelatin of a lower viscosity versus said gelatin of a higher viscosity being > 0.1.

2. An imaging element according to claim 1 wherein said at least one gelatin species with a viscosity lower than 20 mPas has a viscosity lower than 15 mPas.

3. An imaging element according to claim 1, wherein said at least one gelatin species with a viscosity lower than 20 mPas is contained in the photosensitive layer.

4. An imaging element according to claim 3, wherein the weight ratio in said layer of said gelatin of a viscosity lower than 20 mPas versus said gelatin of a higher viscosity is > 0.5.

5. An imaging element according to claim 1, wherein the gelatin layer(s) is(are) substantially unhardened.

6. An imaging element according to any of claims 1 to 5, wherein at least one layer containing a gelatin species with a viscosity lower than 20 mPas is coated at a pH value not below the iso-electric point of said layer.

7. An imaging element according to claim 1 comprising an intermediate layer between said image receiving layer and said photosensitive layer, said intermediate layer comprising a non-proteinic hydrophilic film-forming polymer or hydrophobic polymer beads having an average diameter not lower than 0.2 µm and having been prepared by polymerization of an ethylenically unsaturated monomer.

8. A method for making an improved offset printing plate according to the silver salt diffusion transfer process comprising the steps of:
(a) image-wise exposing an imaging element according to claim 1,
(b) applying an aqueous alkaline solution to the imaging element in the presence of (a) developing agent(s) and (a) silver halide solvent(s) to form a silver image in said photosensitive layer and to allow unreduced silver halide or complexes formed thereof to diffuse image-wise from the photosensitive layer to said image receiving layer to produce therein a silver image,
(c) treating the imaging element to remove the layer(s) on top of said image receiving layer, thereby uncovering said silver image formed in said image receiving layer.

9. A method according to claim 9 wherein said imaged surface obtained after removing the photosensitive layer and the intermediate layer, is treated with a fixer to enhance the water-receptivity of the non-image areas and to enhance the ink-receptivity of the image areas.

## Patentansprüche

1. Ein Bildelement, das der angegebenen Reihe nach (i) einen hydrophilen Träger, (ii) eine Bildempfangsschicht mit physikalischen Entwicklungskeimen und (iii) eine photoempfindliche, eine Silberhalogenidemulsion enthaltende, in wasserdurchlässigem Verhältnis mit der Bildempfangsschicht stehende Schicht enthält, dadurch gekennzeichnet, daß die photoempfindliche Schicht und/oder gegebenenfalls eine andere in wasserdurchlässigem Verhältnis damit stehende Schicht wenigstens eine Gelatineart, von der eine 10 gew.-%ige wäßrige Lösung bei 36°C und einem pH-Wert von 6 eine Viskosität von weniger als 20 mPa.s bei einer Schubgeschwindigkeit von 1.000 s⁻¹ aufweist, und eine Gelatine, von der eine 10 gew.-%ige wäßrige Lösung bei 36°C und einem pH-Wert von 6 eine Viskosität von wenigstens 20 mPa.s bei einer Schubgeschwindigkeit von 1.000 s⁻¹ aufweist, enthält, wobei das Gewichtsverhältnis in dieser Schicht der Gelatine mit einer niedrigeren Viskosität zur Gelatine mit einer höheren Viskosität >0,1 beträgt.

2. Ein Bildelement nach Anspruch 1, dadurch gekennzeichnet, daß die Gelatineart mit einer Viskosität von weniger als 20 mPa.s eine Viskosität von weniger als 15 mPa.s hat.

3. Ein Bildelement nach Anspruch 1, dadurch gekennzeichnet, daß die Gelatineart mit einer Viskosität von weniger als 20 mPa.s in der photoempfindlichen Schicht enthalten ist.

4. Ein Bildelement nach Anspruch 3, dadurch gekennzeichnet, daß das Gewichtsverhältnis in dieser Schicht der Gelatine mit einer Viskosität von weniger als 20 mPa.s zur Gelatine mit einer höheren Viskosität >0,5 beträgt.

5. Ein Bildelement nach Anspruch 1, dadurch gekennzeichnet, daß die Gelatineschicht(en) wesentlich ungehärtet ist (sind).

6. Ein Bildelement nach irgendeinem der Ansprüche 1 bis 5, dadurch gekennzeichnet, daß wenigstens eine Schicht, die eine Gelatineart mit einer Viskosität von weniger als 20 mPa.s enthält, bei einem nicht unter dem isoelektrischen Punkt der Schicht liegenden pH-Wert aufgetragen wird.

7. Ein Bildelement nach Anspruch 1, das zwischen der Bildempfangsschicht und der photoempfindlichen Schicht eine Zwischenschicht enthält, wobei die Zwischenschicht ein nicht-proteinhaltiges hydrophiles filmbildendes Polymeres oder hydrophobe, durch Polymerisation eines ethylenisch ungesättigten Monomeres hergestellte Polymerperlen mit einem durchschnittlichen Durchmesser von nicht weniger als 0,2 µm enthält.

8. Ein Verfahren zur Herstellung einer verbesserten Offsetdruckplatte nach dem Silbersalz-Diffusionsübertragungsverfahren, das die folgenden Stufen umfaßt :
(a) die bildmäßige Belichtung eines Bildelements nach Anspruch 1,
(b) den Auftrag einer wäßrigen, alkalischen Lösung auf das Bildelement in Gegenwart von mindestens einer Entwicklersubstanz und mindestens einem Silberhalogenidlösungsmittel, wodurch in der photoempfindlichen Schicht ein Silberbild erstellt wird und das nichtreduzierte Silberhalogenid oder dessen daraus gebildete Komplexe bildmäßig von der photoempfindlichen Schicht zu der Bildempfangsschicht überdiffundieren können, um darin ein Bild zu erzeugen,
(c) die derartige Verarbeitung des Bildelements, das die auf der Bildempfangsschicht befindliche(n) Schicht(en) entfernt wird (werden) und dabei das in der Bildempfangsschicht erzeugte Silberbild freigelegt wird.

9. Ein Verfahren nach Anspruch 9, dadurch gekennzeichnet, daß die nach der Entfernung der photoempfindlichen Schicht und der Zwischenschicht erhaltene, mit einem Bild versehene Oberfläche mit einem Fixiermittel verarbeitet wird, um die Hydropholie der Nicht-Bildbereiche und die Farbaufnahmefähigkeit der Bildbereiche zu verbessern.

## Revendications

1. Elément formateur d'image comprenant, dans l'ordre donné, (i) une base hydrophile, (ii) une couche de réception d'image contenant des germes de développement physique et (iii) une couche photosensible contenant une émulsion à l'halogénure d'argent en relation de perméabilité à l'eau avec ladite couche de réception d'image, caractérisé en ce que ladite couche photosensible et/ou une autre couche facultative en relation de perméabilité à l'eau avec elle contiennent au moins une espèce de gélatine dont une solution aqueuse à 10% en poids à 36°C et à un pH de 6 possède une viscosité inférieure à 20 mPa.s à un taux de cisaillement de 1000 s⁻¹ et une gélatine dont une solution aqueuse à 10% en poids à 36°C et à un pH de 6 possède une viscosité d'au moins 20 mPa.s à un taux de cisaillement de 1000 s⁻¹, le rapport pondéral dans ladite couche de ladite gélatine présentant une viscosité inférieure par rapport à ladite gélatine présentant une viscosité supérieure étant > 0,1.

2. Elément formateur d'image selon la revendication 1, dans lequel la ou lesdites espèces de gélatine possédant une viscosité inférieure à 20 mPa.s possède une viscosité inférieure à 15 mPa.s.

3. Elément formateur d'image selon la revendication 1, dans lequel la ou lesdites espèces de gélatine possédant une viscosité inférieure à 20 mPa.s est contenue dans la couche photosensible.

4. Elément formateur d'image selon la revendication 3, dans lequel le rapport pondéral dans ladite couche de ladite gélatine possédant une viscosité inférieure à 20 mPa.s par rapport à ladite gélatine possédant une viscosité supérieure est > 0,5.

5. Elément formateur d'image selon la revendication 1, dans lequel la ou les couches de gélatine est/sont essentiellement non durcie(s).

6. Elément formateur d'image selon une quelconque des revendications 1 à 5, dans lequel au moins une couche contenant une espèce de gélatine possédant une viscosité inférieure à 20 mPa.s est coulée à une valeur de pH qui n'est pas inférieure au point isoélectrique de ladite couche.

7. Elément formateur d'image selon la revendication 1, comprenant une couche intermédiaire entre ladite couche de réception d'image et ladite couche photosensible, ladite couche intermédiaire comprenant un polymère filmogène hydrophile non protéinique ou des perles de polymères hydrophobes possédant un diamètre moyen qui n'est pas inférieur à 0,2 µm et que l'on a préparées par polymérisation d'un monomère à insaturation éthylénique.

8. Procédé pour fabriquer un cliché offset perfectionné conformément au procédé de transfert de sels d'argent par diffusion, comprenant les étapes consistant à:
(a) exposer en forme d'image un élément formateur d'image selon la revendication 1,
(b) appliquer une solution alcaline aqueuse sur l'élément formateur d'image en présence d'un ou de plusieurs agents développateurs et d'un ou de plusieurs solvants de l'halogénure d'argent pour former une image argentique dans ladite couche photosensible et pour permettre à de l'halogénure d'argent non réduit ou à des complexes formés à partir de ce dernier de diffuser sous forme d'image depuis la couche photosensible jusque dans ladite couche de réception d'image pour y générer une image argentique,
(c) traiter l'élément formateur d'image pour éliminer la ou les couches par-dessus ladite couche de réception d'image, découvrant ainsi ladite image argentique formée dans ladite couche de réception d'image.

9. Procédé selon la revendication 8, dans lequel ladite surface contenant une image obtenue après élimination de la couche photosensible et de la couche intermédiaire est traitée avec un fixateur pour amplifier l'acceptation d'eau des zones exemptes d'image et pour amplifier l'acceptation d'encre des zones d'image.
